# EUROPÄISCHE PATENTANMELDUNG

(11) **EP 0 833 388 A2**
(43) Veröffentlichungstag der Anmeldung: **01.04.1998**
(21) Anmeldenummer: 97116091.6
(22) Anmeldetag: 16.09.1997
(51) Int. Cl.: H01L 29/74

(54) **Halbleiterbauelement mit Lateralwiderstand**

(30) Priorität: 30.09.1996 DE 19640311
(71) Anmelder: EUPEC Europäische Gesellschaft für Leistungshalbleiter mbH & Co. KG, D-59581 Warstein (DE)
(72) Erfinder: Schulze, Hans-Joachim, Dr., 85521 Ottobrunn (DE)
(74) Vertreter: Fuchs, Franz-Josef, Dr.-Ing.

(57) **Zusammenfassung**

Die Erfindung betrifft ein Halbleiterbauelement bestehend aus einem Halbleiterkörper (1) mit mindestens einem integriertem Lateralwiderstand (6), wobei sich der Lateralwiderstand (6) aus der Dotierungskonzentration im Widerstandsbereich (7) ergibt. Der Widerstandsbereich (7) befindet sich in einem von der Oberfläche des Halbleiterbauelements zugänglichen Bereich und besitzt eine definierte Dotierungskonzentration. Zusätzlich sind Streuzentren (11) im Bereich des Lateralwiderstandes (6) vorgesehen, welche die Temperaturabhängigkeit des Lateralwiderstandes (6) erniedrigen.

## Beschreibung

Die Erfindung betrifft ein Halbleiterbauelement bestehend aus einem Halbleiterkörper mit mindestens einem integriertem Lateralwiderstand mit den nachfolgenden Merkmalen,
- der Lateralwiderstand ergibt sich aus der Dotierungskonzentration im Widerstandsbereich,
- der Widerstandsbereich befindet sich in einem von der Oberfläche des Halbleiterbauelements zugänglichen Bereich,
- der Widerstandsbereich besitzt eine definierter Dotierungskonzentration,
   und ein Verfahren zu dessen Herstellung.

Lateralwiderstände spielen in der Leistungs-Halbleiterbauelementen eine große Rolle. Üblicherweise werden Lateralwiderstände in Leistungsthyristoren integriert, um die Stromanstiegsgeschwindigkeit beim Einschalten des Thyristors zu begrenzen. Ohne diese Lateralwiderstände als Strombegrenzer könnten die Halbleiterbauelemente zerstört werden.

Aus den Konferenzunterlagen zur "IEEE International Conference: Thyristors and variable and static equipment for AC and DC Transmission", 30.11.1981 bis 03.12.1981 in London aus der darin enthaltenen Veröffentlichung von V.A.K.Temple (GE) zum Thema "Advanced light triggered thyristors for electric power systems", insbesondere Seite 90, Figur 7 und Seite 91, Figur 10 ist ein gattungsgemäßes Halbleiterbauelement und ein Verfahren zu dessen Herstellung bekannt. Insbesondere handelt es sich bei dem Halbleiterbauelement um einen Leistungsthyristor mit Amplifying-Gate-Struktur. Bei diesem Thyristor wird ein definierter Lateralwiderstand dadurch erzeugt, daß erst eine p-Basis durch Diffusion gebildet wird und dann am Ort des zu realisierenden Widerstandes die p-Basis dünner geätzt wird.

In EP 0 472 880 ist ebenfalls ein Halbleiterbauelement der eingangs genannten Art angegeben. Es ist hier ein Thyristor mit Lateralwiderstand angegeben, dessen Widerstandsbereich eine definiert geringere Dotierungskonzentration als die ihn umgebende Schicht aufweist. Üblicherweise werden die in Halbleiterbauelemente integrierten Widerstände durch Eindiffusion bzw. Implantation von Dotieratomen, beispielsweise Bor oder Aluminium, erzeugt. Die Steuerung des Widerstandswertes kann im Fall des Einbringens der Dotieratome durch Ionenimplantation zum Beispiel über die gewählte Dosis erfolgen. Werden die Dotieratome durch Diffusion eingebracht, bietet sich beispielsweise eine strukturierte Ätzung der Dotierschichten an, um den Widerstand gezielt einstellen zu können. Ein Verfahren dieser Art ist in EP 0 472 880 genau beschrieben. Es ist dadurch möglich, Lateralwiderstände mit gut reproduzierbaren Widerstandswerten zu erzeugen.

Insbesondere die durch spezielle Dotierungsvorgänge realisierten Lateralwiderstände heizen sich während des Stromflusses durch Joulesche Wärme zum Teil stark auf. Der Widerstandswert des Lateralwiderstandes steigt dadurch, da die Zahl der Phononen mit der Temperatur und damit die Streuung an diesen zunimmt. Durch den erhöhten Widerstand steigt wieder die Dissipation usw. Dieses gegenseitige Aufschaukeln des Widerstandswertes und der Temperatur kann im starken Belastungsfall zur Zerstörung des Halbleiterbauelements führen.

Aufgabe der Erfindung ist es, ein Halbleiterbauelement der genannten Art so weiterzubilden, daß dessen Lateralwiderstand im Temperaturbereich des Bauelementbetriebs weitgehend temperaturunabhängig ist und sich mit minimalem prozeßtechnischem Aufwand gut reproduzierbar im Halbleiterbauelement integrieren läßt.

Die Aufgabe wird erfindungsgemäß durch den kennzeichnenden Teil von Patentanspruch 1 gelöst. Es ist hier ein Halbleiterbauelement mit einem Lateralwiderstand angegeben, der Streuzentren im Bereich des Lateralwiderstandes aufweist, die die Temperaturabhängigkeit des Lateralwiderstandes herabsetzen. Der Widerstand ist konzentrisch angeordnet und weist eine Ausdehnung von zum Beispiel 2 mm auf.

Die Ausgestaltung der Streuzentren ist Bestandteil der Patentansprüche 2 bis 4. Die Streuzentren bestehen dabei im wesentlichen aus Defekten, die durch Bestrahlung mit nichtdotierenden, hochenergetischen Teilchen, beispielsweise α-Teilchen, Protonen oder Elektronen, erzeugt werden. Wird eine sehr starke Schädigung des Kristalls gewünscht, kann der Halbleiterkörper auch mit schwereren Teilchen wie zum Beispiel Sauerstoffionen, Siliziumionen oder ähnlichen Teilchen bestrahlt werden. Als Bestrahlungsquelle wird bevorzugt wegen der Möglichkeit der einfachen Beschleunigung der Teilchen ein Hochenergieionenimplanter verwendet. Es ist aber auch denkbar, ungeladene Teilchen wie zum Beispiel Neutronen zur Bestrahlung zu verwenden.

In Patentanspruch 5 werden die Defekte als Frenkel-Defekte und/oder Schottky-Defekte charakterisiert. Diese Defekte sind Punktfehler im Kristallgitter, die sich als Leerstellen auswirken. Ein Frenkel-Defekt ist eine Leerstelle, bei der das dazugehörige Atom sich auf einem Zwischengitterplatz in der Nähe der Leerstelle befindet. Ist das zu einer Leerstelle zugehörige Atom an die Oberfläche gewandert, liegt ein Schottky-Defekt vor. Es sind aber auch andere Defekte wie zum Beispiel Sauerstoff-Leerstellenkomplexe oder Doppelleerstellen denkbar.

Patentanspruch 6 beansprucht das Halbleiterbauelement als Thyristor. Der Thyristor enthalt mindestens eine Gateelektrode, Emitterelektrode und Anode. Insbesondere bei Thyristoren mit hohen schaltbaren Strömen spielen integrierte Lateralwiderstände als Strombegrenzer eine sehr große Rolle und verhindern so das Zerstören des Bauelementes.

Patentanspruch 7 beansprucht einen mehrstufigen Thyristor. Thyristoren mit sogenannter Amplifying-Gate-Struktur bestehen aus einer Parallelschaltung von mindestens einem Hauptthyristor und mindestens einem Hilfsthyristor. Mehrstufige Thyristoren mit Amplifying-Gate-Struktur sind vorteilhaft insbesondere bei geringen Zündströmen im primären Zündbereich der Thyristoren, wie zum Beispiel bei lichtzündbaren Thyristoren. Der Lichtimpuls kann beispielsweise durch einnen Laser oder eine Laserdiode erzeugt werden.

Die Form des Thyristors ist Gegenstand des Patentanspruchs 8. Der Thyristor ist vorteilhafterweise ein Ringthyristor oder ringförmiger Thyristor. Dadurch erreicht man eine gleichmäßige Stromdurchflutung und eine höhere schaltbare Leistung des Thyristors.

In einer Weiterbildung gemäß Patentanspruch 9 weisen die Halbleiterbauelemente vorteilhafterweise eine Spannungssollbruchstelle im zentralen Bereich des Halbleitertbauelementes auf. Diese sind als Krümmung des pn-Übergangs zwischen anodenseitiger und katodenseitiger Basiszone ausgebildet und dienen dem Überspannungsschutz für das Halbleiterbauelement.

In einer Weiterbildung gemaß Patentanspruch 10 sind außerdem Aussparungen am Rand des Halbleiterbauelementes vorgesehen. Diese Aussparungen definieren eine Randstruktur wodurch vermieden wird, daß ein verfrühter Spannungsdurchbruch im Randbereich des Halbleiterbauelementes auftritt.

In einer Weiterbildung gemäß Patentanspruch 11 kann der Lateralwiderstand zwischen jedem der Haupt-und Hilfsthyristoren angeordnet sein. Außerdem ist es denkbar, daß mehrere Lateralwiderstände vorgesehen sind.

Ein bevorzugtes Herstellungsverfahren des erfindungsgemäßen Halbleiterbauelementes ist Gegenstand von Patentanspruch 12.

Dadurch, daß der endgültige Widerstandswert des Lateralwiderstands am fertigen Bauelement eingestellt werden kann, läßt sich vorteilhafter weise bei zu niedrigem Widerstand der Lateralwiderstand durch eine Nachbestrahlung auf einfache Weise nachjustieren.

Um die Temperaturabhängigkeit des in dem Halbleiterbauelement integrierten Lateralwiderstands zu erniedrigen, zielt das hier beschriebene Verfahren darauf ab, den Einfluß der Streuung der freien Ladungsträger an Phononen zu reduzieren.

Allgemein ergibt sich der Widerstand über den spezifischen Widerstand ρ. Dabei ist ρ direkt proportional zu 1/µ, wobei µ der Beweglichkeit der freien Ladungsträger entspricht. Die Beweglichkeit µ wird bei sehr reinen Halbleitern überwiegend durch Stöße mit Phononen begrenzt und bei defektreichen Halbleitern auch durch die Stöße mit Gitterfehlern. Hierbei gilt, daß sich die reziproke mittlere Zeit bis zum Auftreten eines Stoßprozesses aus der Summe der reziproken mittleren Zeit bis zum Auftreten einer Streuung an Phononen und der reziproken mittleren Zeit bis zum Auftreten einer Streuung an Störstellen zusammensetzt.

Aus dieser Erkenntnis heraus liegt der Erfindung die Idee zugrunde, den Halbleiterkristall im Widerstandsbereich gezielt so stark zu schädigen, daß im Bereich der Betriebstemperatur des Halbleiterbauelementes der Anteil der Stöße der freien Ladungsträger mit Gitterfehlern, deren Dichte im Gegensatz zu den Phononen nicht temperaturabhängig ist, den Anteil der Stöße der freien Ladungsträger mit Phononen möglichst übertrifft.

Realisieren läßt sich eine derartige kontrollierte Erzeugung von Defekten im Bereich des Lateralwiderstandes zum Beispiel durch die beschriebene Bestrahlung des Widerstandsbereiches mit hochenergetischen Teilchen.

Die Erfindung wird nachfolgend anhand des in der einzigen Figur der Zeichnung dargestellten Ausführungsbeispiels näher erläutert. Als Ausführungsbeispiel der erfindungsgemäßen Lateralwiderstandsstrukur dient dabei ein mehrstufiger Thyristor.

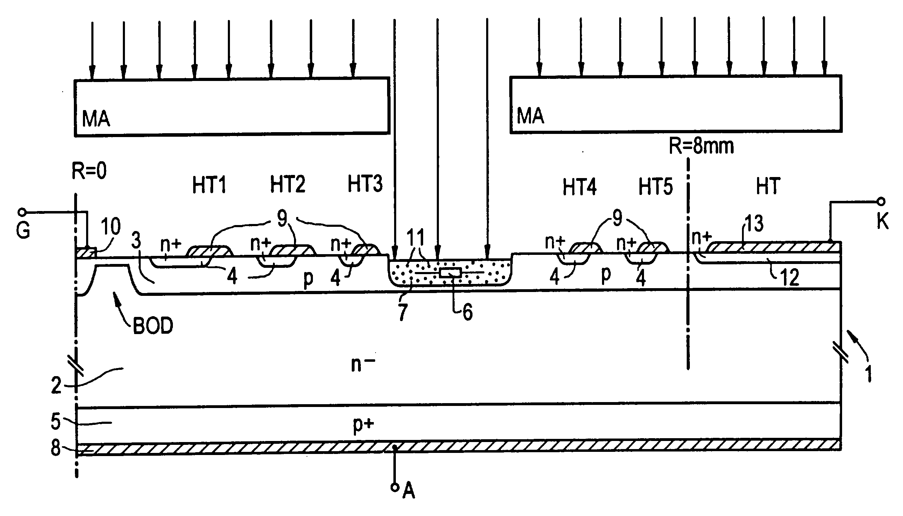

Figur 1 zeigt eine Schnittdarstellung eines Thyristors mit erfindungsgemäßen Lateralwiderstand und Amplifying-Gate-Struktur.

Ein Halbleiterkörper 1, beispielsweise eine Siliziumscheibe, enthält eine schwach n⁻-dotierte Innenzone 2. Katodenseitig schließt sich eine p-dotierte Basiszone 3 an. In der Basiszone 3 sind mehrere n⁺-dotierte Emitterzonen 4, 12 eingebettet. Im vorliegenden Beispiel handelt es sich dabei zum einen um die Hilfsemitterzonen 4 der Hilfsthyristoren HT1 - HT5 und die Hauptemitterzone 12 des Hauptthyristors HT. Die Hilfsemitterzonen 4 der Hilfsthyristoren HT1 - HT5 sind jeweils über Hilfsemitterelektroden 9 kontaktiert. Außerdem kontaktieren die Hilfsemitterelektroden 9 an ihrer Außenseite auch die Basiszone 3. Die Hauptemitterzone 12 des Haupthyristors HT ist über die Hauptemitterelektrode 13 mit dem Katodenanschluß K verbunden. Zusätzlich ist die Basiszone 3 im zentralen Bereich des Thyristors über die Gatemetallisierung 10 kontaktiert. Die Gatemetallisierung 10 ist mit dem Gateanschluß G des Thyristors verbunden. Anodenseitig schließt sich an die Innenzone 2 die p⁺-dotierte anodenseitige Emitterzone 5 an. Die anodenseitige Emitterzone 5 wird großflächig über eine übliche Metallisierung 8 kontaktiert. Diese Metallisierung 8 bildet den Anodenanschluß A.

In der Basiszone 3 ist ein eingebetteter Bereich 7 vorgesehen, der den Lateralwiderstand 6 enthält. Der eingebettete Bereich 7 grenzt an die Oberfläche des Halbleiterkörpers 1 an. In dem eingebetteten Bereich 7 ist eine genau festgelegte Dotierungsdosis, beispielsweise durch Ionenimplantation, eingebracht worden. Im folgenden wird dieser eingebrachte Bereich als Widerstandsbereich 7 bezeichnet. Die Dotierungskonzentration im Widerstandsbereich 7 bestimmt den Widerstandswert des Lateralwiderstandes 6.

Zusätzlich sind im Widerstandsbereich 7 Streuzentren 11 eingebracht. Die Streuzentren 11 können Defekte im Kristallgitter des Halbleiters sein, die zum Beispiel durch Bestrahlung mit nichtdotierenden, hochenergetischen Teilchen erzeugt wurden. Diese Teilchen können beispielsweise α-Teilchen oder Protonen sein. Ist eine sehr starke Schädigung des Kristalls erforderlich, kann der Halbleiterkörper auch mit schwereren Teilchen wie zum Beispiel Sauerstoffionen oder Siliziumionen bestrahlt werden. Es können aber auch neutrale Teilchen wie zum Beispiel Neutronen zur Bestrahlung verwendet werden. Als Bestrahlungsquelle kann ein Hochenergieionenimplanter dienen. Durch die Bestrahlung können im Kristallgitter Punktfehler wie zum Beispiel Frenkel-Defekte oder Schottky-Defekte gebildet werden. Ein Frenkel-Defekt ist eine Leerstelle, bei der das dazugehörige Atom sich auf einem Zwischengitterplatz in der Nähe der Leerstelle befindet. Ist das zu einer Leerstelle zugehörige Atom an die Oberfläche gewandert, liegt ein Schottky-Defekt vor. Durch die Bestrahlung können aber auch andere Defekte wie zum Beispiel Sauerstoff-Leerstellenkomplexe oder Doppelleerstellen erzeugt werden.

Somit wird der Widerstandswert des Lateralwiderstandes 6 durch die Dotierungskonzentration und die Konzentration der Streuzentren 11 im Widerstandsbereich bestimmt.

Der Thyristor aus Figur 1 ist ringförmig aufgebaut, wobei bei R=0 die Thyristormitte und bei R=8mm das Ende der Amplifying-Gate-Struktur anzunehmen ist. In Figur 1 ist der Übersicht wegen nur die rechte Hälfte des Thyristorquerschnitts gezeigt. Der Thyristor besteht aus den fünf ringförmigen Hilfsthyristoren HT1 - HT5 der Amplifying-Gate-Struktur und einem Hauptthyristor HT, der kreisringförmig um die Hilfsthyristoren HT1 - HT5 angeordnet ist. Im vorliegenden Beispiel befindet sich der Widerstandsbereich 7 zwischen dem dritten und vierten Hilfsthyristor HT3, HT4. Im Zentralbereich des Thyristors befindet sich außerdem der Gateelektrode G, die die Basiszone 3 kontaktiert. Im Bereich der Thyristormitte weist die Basiszone 3 eine Spannungssollbruchstelle BOD auf. Die Spannungssollbruchstelle BOD ist als Krümmung des pn-Übergangs zwischen Innenzone 2 und Basiszone 3 ausgebildet und dient dem Überspannungsschutz für das Halbleiterbauelement. Zusätzlich können im Randbereich des Thyristors nahe der Oberfläche ringförmige Aussparungen zur Erzeugung einer Randstruktur vorgesehen sein (in Figur 1 nicht dargestellt). Diese Randstrukturen verhindern, daß Oberflächenleckströme über den Rand des Halbleiterbauelementes abfließen.

Der Lateralwiderstand hat folgende Funktion: Erhält der Gateanschluß G eine positive Spannung gegenüber der Kathode K, so zünden zunächst die Hilfsthyristoren HT1 - HT3 und über den Lateralwiderstand 6 danach auch die Hilfsthyristoren HT4, HT5 und schließlich der Hauptthyristor HT. Der Lateralwiderstand 6 hat somit eine Strombegrenzerwirkung und verhindert, daß beim Zünden zu große Ströme auf einmal geschaltet werden, die zur Zerstörung des Halbleiterbauelementes führen können.

Im Fall geringer Zündströme können auch mehrstufige Amplifying-Gate-Stufen eingesetzt werden. Solche mehrstufige Thyristoren mit Amplifying-Gate-Struktur bestehen aus einer Parallelschaltung von mehreren Thyristoren. Wird der erste Thyristor beispielsweise durch die Gatespannung bzw. Lichtimpuls gezündet, dann dient dessen Anodenstrom zum Zünden der nachfolgenden Thyristors usw. Somit lassen sich nacheinander alle Thyristoren der Amplifying-Gate-Anordnung zünden.

Vorteilhafterweise ist in jeder einzelnen Stufe der Amplifying-Gate-Anordnung, also zwischen jeweils zwei Hilfsthyristoren HT1 -HT5, sowie zwischen einem Hilfsthyristor HT5 und dem Hauptthyristor HT ein entsprechender Lateralwiderstand 6 vorgesehen.

Die Widerstandswerte bei Thyristoren mit Amplifying-Gate-Struktur bewegen sich in der Größenordnung von typischerweise 20-50 Ω. Die Widerstände dienen als Schutzwiderstände und bewirken, daß der Stromanstieg im primären Zündbereich begrenzt wird.

Nachfolgend ist ein bevorzugtes Verfahren zur Herstellung der Streuzentren 11 im Widerstandsbereich 7 angegeben.

Das fertig prozessierte Halbleiterbauelement wird katodenseitig maskiert. Da die Lateralwiderstände von Thyristoren relativ groß dimensioniert sind, kann als Maske MA beispielsweise eine strukturierte beispielsweise 3 mm dicke Metallblende dienen, die die Bereiche der Scheibenoberfläche außerhalb des Widerstandsbereichs 7 abdeckt. Der Halbleiterkörper 1 wird katodenseitig mit hochenergetischen Teilchen bestrahlt. Dadurch werden im Kristallgitter Defekte generiert, die als Streuzentren 11 wirken. Die Tiefenverteilung der als Streuzentren wirkenden Defekte kann beispielsweise durch die Wahl der Bestrahlungsenergie gesteuert werden. Insbesondere bei Widerstandsstrukturen, die in vertikaler Richtung eine verhältnismäßig große Ausdehnung von beispielsweise 80 µm aufweisen, kann durch Mehrfachbestrahlungen bei unterschiedlichen Strahlungsenergien eine homogene Verteilung der Streuzentren im Widerstandsbereich 7 erzeugt werden.

Aus Stabilitätsgründen empfiehlt es sich, nach der Bestrahlung einen Temperaturschritt vorzunehmen. Dabei wird der Halbleiterkörper bei Temperaturen zwischen 220°C und 270°C für mehrere Stunden (beispielsweise 15 h) getempert.

Anstelle der Bestrahlungstechnik ist auch die lokale Eindiffusion von nichtdotierenden Atomen denkbar.

Der Widerstandswert des Lateralwiderstands 6 wird durch die Bestrahlung zwangsläufig erhöht. Dementsprechend muß dafür die Konzentration der freien Ladungsträger ebenfalls erhöht werden, um den gewünschten Widerstandswert zu erzielen. Dies erfordert eine Anhebung der Dotierungskonzentration im Widerstandsbereich 7.

Das Verfahren zur Herstellung eines definierten temperaturunabhängigen Lateralwiderstands 6 ist für optisch zündbare Thyristoren sowie für Thyristoren, die durch eine Gateelektrode gesteuert werden, anwendbar. Es kann aber gegebenenfalls auch bei Herstellung anderer Halbleiterbauelemente Anwendung finden. Besondere Bedeutung hat es bei Thyristoren mit integriertem Überspannungsschutz (BOD-Struktur).

Ein weiterer wichtiger Vorteil beim Einsatz des erfindungsgemäßen Verfahrens liegt darin, daß der endgültige Widerstandswert des Lateralwiderstands 6 am fertigen Bauelement eingestellt werden kann. Stellt sich beispielsweise bei der Widerstandsmessung nach der ersten Bestrahlung heraus, daß der Widerstandswert nicht hoch genug ist, läßt sich der Widerstand durch eine Nachbestrahlung auf einfache Weise nachjustieren.

## Patentansprüche

1. Halbleiterbauelement bestehend aus einem Halbleiterkörper (1) mit mindestens einem integriertem Lateralwiderstand (6) mit den nachfolgenden Merkmalen,
- der Lateralwiderstand (6) ergibt sich aus der Dotierungskonzentration im Widerstandsbereich (7),
- der Widerstandsbereich (7) befindet sich in einem von der Oberfläche des Halbleiterbauelements zugänglichen Bereich,
- der Widerstandsbereich (7) besitzt eine definierte Dotierungskonzentration,
**dadurch gekennzeichnet,**
daß Streuzentren (11) im Bereich des Lateralwiderstandes (6) vorgesehen sind, welche die Temperaturabhängigkeit des Lateralwiderstandes (6) herabsetzen.

2. Halbleiterbauelement nach Anspruch 1,
**dadurch gekennzeichnet,**
daß die Streuzentren (11) im wesentlichen Defekte im Halbleiterkristall sind, die durch Bestrahlung mit nichtdotierenden, hochenergetischen Teilchen im Kristallgitter erzeugt werden.

3. Halbleiterbauelement nach Anspruch 2,
**dadurch gekennzeichnet,**
daß die Defekte durch Bestrahlung des Halbleiterkörpers (1) mit α-Teilchen und/oder Protonen und/oder Elektronen erzeugt worden sind.

4. Halbleiterbauelement nach einem der Ansprüche 2 bis 3,
**dadurch gekennzeichnet,**
daß die Defekte durch Bestrahlung des Halbleiterkörpers (1) mit Sauerstoffionen und/oder Siliziumionen erzeugt worden sind.

5. Halbleiterbauelement nach einem der Ansprüche 2 bis 4,
**dadurch gekennzeichnet,**
daß es sich bei den Defekten um Frenkel-Defekte und/oder Schottky-Defekte und/oder Sauerstoff-Leerstellenkomplexe und/oder Doppelleerstellen handelt.

6. Halbleiterbauelement nach einem der Ansprüche 1 bis 5,
**dadurch gekennzeichnet,**
daß das Halbleiterbauelement ein Thyristor ist enthaltend mindestens eine Gateelektrode (G), eine Kathode (K) und eine Anode (G).

7. Halbleiterbauelement nach Anspruch 6,
**dadurch gekennzeichnet,**
daß der Thyristor mehrstufig ausgebildet ist und mindestens einen Hauptthyristor und mindestens einen Hilfsthyristor (HT1 - HT5) enthält.

8. Halbleiterbauelement nach einem der Ansprüche 6 bis 7,
**dadurch gekennzeichnet,**
daß der Thyristor ein Ringthyristor oder ringförmiger Thyristror ist und die Thyristorstrukturen in der Ebene der Oberfläche kreisförmig, kreisringförmig oder polygonförmig ausgebildet sind.

9. Halbleiterbauelement nach einem der Ansprüche 1 bis 8,
**gekennzeichnet durch**
eine Spannungssollbruchstelle (BOD) im zentralen Bereich des Halbleiterbauelementes.

10. Halbleiterbauelement nach einem der Ansprüche 1 bis 9,
**gekennzeichnet durch**
eine Aussparungen am Rand des Thyristors zur Erzeugung einer Randstruktur.

11. Halbleiterbauelement nach einem der Ansprüche 6 oder 10,
**dadurch gekennzeichnet,**
daß sich der Lateralwiderstand (6) zwischen zwei Hilfsthyristoren (HT1 - HT5) und/oder zwischen einem Hilfsthyristor(HT1 - HT5) und einem Hauptthyristor (HT) befindet.

12. Herstellungsverfahren für einen Halbleiterbauelement mit integriertem Lateralwiderstand nach einem der Ansprüche 1 bis 11,
**dadurch gekennzeichnet,**
daß folgende Verfahrensschritte zur Erzeugung der Streuzentren (11) im Widerstandsbereich (7) nacheinander durchgeführt werden:
- das Halbleiterbauelement mit Lateralwiderstand (6) wird kathodenseitig maskiert, wobei die Bereiche außerhalb des Widerstandsbereichs (7) durch eine Maske (MA) abgedeckt sind,
- das Halbleiterbauelement wird katodenseitig mit hochenergetischen, nichtdotierenden Teilchen bestraht,
- abschließende Temperung des Halbleiterkörpers (1) zur Stabilisierung der Streuzentren (11).
